# EUROPEAN PATENT APPLICATION

(11) **EP 0 844 674 A1**
(43) Date of publication of application: **27.05.1998**
(21) Application number: 97924285.6
(22) Date of filing: 29.05.1997
(51) Int. Cl.: H01L 33/00

(54) **SEMICONDUCTOR LIGHT EMITTING DEVICE AND METHOD FOR MANUFACTURING THE SAME**

(30) Priority: 30.05.1996 JP 136794/96
(71) Applicant: ROHM CO., LTD., Kyoto-shi Kyoto 615 (JP)
(72) Inventor: ABE, Hiromitsu, Rohm Co., Ltd, Kyoto-shi, Kyoto 615 (JP)
(74) Representative: Pellmann, Hans-Bernd, Dipl.-Ing.
(86) International application number: JP9701861
(87) International publication number: WO9745881

(57) **Abstract**

When epitaxially growing on an n-type GaAs semiconductor substrate (1), in order, AlGaInP-based semiconductors of an n-type clading layer (3), an active layer, and a p-type cladding layer to provide a doublehetero structure of an overlying light emitting layer forming portion (10), the p-type cladding layer is grown to a carrier concentration of 1× 10¹⁶ to 5 × 10¹⁶ cm⁻³ . Further, a window laer (6) of a p-type AlGaAs-based compound semiconductor is grown thereon, and a p-side electrode (8) and an n-side electrode (9) are provided. With this structure, the p-type impurity is suppressed to a minimal degree from diffusing into the active layer during growing the semiconductor layers, thereby providing a semiconductor light emitting device that is high in light emitting efficiency and brightness.

## Description

### TECHNICAL FIELD

This invention relates to a semiconductor light emitting device, and a method of manufacturing the same, adapted to improve light emitting efficiency to be utilized not only for light sources requiring high brightness such as outdoor displays, automobile tail lamps, direction indicators, and so on, but also low power-consumption light sources such as back-light light sources, indicator lighting units, and so on for battery-driven portable appliances.

### BACKGROUND ART

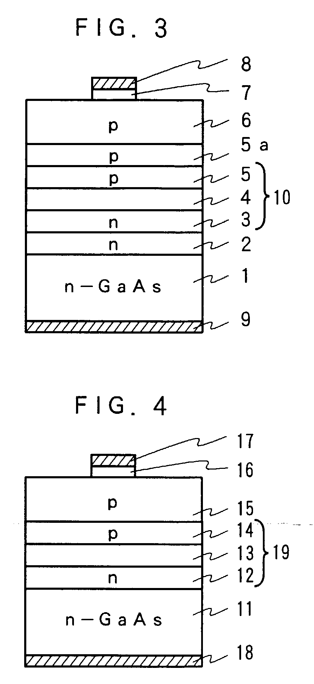

The conventional semiconductor light emitting device for emitting visible light has such a structure as disclosed by Japanese Provisional Patent Publication (Kokai) No. H4-212479 which employs, for example, an AlGaInP-based semiconductor material for its light emitting layer as shown in Fig. 4. That is, in Fig. 4, on a n-type GaAs semiconductor substrate 11 are epitaxially grown, for example, an n-type cladding layer 12 of an n-type AlGaInP-based semiconductor material, an active layer 13 of a non-doped AlGaInP-based semiconductor material, a p-type cladding layer 14 of a p-type AlGaInP-based semiconductor material, and a window layer (current diffusing layer) of an AlGaAs-based semiconductor material. An upper electrode (p-side electrode) 17 is provided through a GaAs contact layer 16 and a lower electrode (n-side electrode) 18 is formed on the backside of the semiconductor substrate, which are respectively formed of an Au-Be-Ni alloy and an Au-Ge-Ni alloy, or the like.

The light emitting device of this structure is of a doublehetero structure having an active layer 13 sandwiched between the both cladding layers 12, 14 to confine carriers therein, wherein the AlGaInP-based materials of the both cladding layer 12, 14 and the active layer 13 constituting a light emitting layer forming portion 19 are selected of their crystal mixture ratio so as to enhance light emitting efficiency. Meanwhile, the cladding layers 12, 14 are formed to have a concentration of carriers of 5× 10¹⁷ to 2× 10¹⁸ cm⁻³ as shown, for example, in Japanese Provisional Patent Publication No. H4-212479. This is because that it is considered the effect of confining carriers becomes ineffective if the carrier concentration becomes excessively low.

With the conventional semiconductor light emitting device structured as shown in Fig. 4, the light emitting efficiency remains low and the brightness will not improve higher than a given value, in what way devising is made therefor. The present inventor has eagerly repeated many studies to improve the light emitting efficiency for semiconductor light emitting devices. As a result, it was found that the lowering in light emitting efficiency and the difficulty in increasing brightness are attributable to p-type impurities such as zinc and magnesium contained in the p-type cladding layer which is liable to diffuse into the active layer to thereby cause deterioration in crystallinity at the interface between the active layer and the p-type cladding layer as well as in the active layer while epitaxially growing the p-type cladding layer or the window layer.

The present invention has been made in order to solve such problems and improve the light emitting efficiency for semiconductor light emitting-devices, and it is an object of the invention to provide a semiconductor light emitting device which is high in light emitting efficiency and brightness by suppressing p-type impurities from diffusing into the active layer to a minimal degree.

It is another object of the present invention to provide a method for manufacturing a semiconductor light emitting device that is high in brightness as above.

### DISCLOSURE OF THE INVENTION

The present inventor has eagerly repeated further studies so that the p-type impurities are prevented from diffusing into the active layer during epitaxially growing the semiconductor layer as stated above. As a result, it was found that the degradation in crystallinity due to diffusion can be suppressed to a minimal degree by controlling the amount of the p-type impurities doped to the p-type cladding layer so that the concentration of carriers within the p-type cladding layer is finally 1× 10¹⁶ to 5× 10¹⁶ cm⁻³ , providing a high-brightness semiconductor light emitting device.

A semiconductr light emitting device according to the present invention comprises: a semiconductor substrate of a first conductivity type; a light emitting layer forming portion formed overlying the semiconductor sbstrate to have an active layer sandwched between an n-type cladding layer and a p-type cladding layer; a window layer of a second conductivity type provided on the light emitting layer forming portion; electrodes respectively provided in electrical connection with the window layer and the semiconductor substrate; and wherein the p-type cladding layer is formed in a carrier concentration of 1 × 10¹⁶ to 5× 10¹⁶ cm⁻³ . With this structure, the absolute amount of the p-type impurity is less so that, even if the p-type impurity diffuses into the active layer side during thereafter growing semiconductor layers, the amount thereof is slight, and it is not caused the deterioration in crystalinity and lowering in light emitting characteristics.

If a p-type second cladding layer is further provided on the opposite side to the p-type cladding layer with respect to the active layer to be formed by a semiconductor layer of the same material basis as the p-type cladding layer to have a carrier concentration of 5 × 10¹⁷ to 2× 10¹⁸ cm⁻³ , it is possible to preferably prevent against voltage drops due to hetero-barriers that are liable to occur between the p-type cladding layer reduced in carrier concentration and the semiconductor layer greater in carrier concentration located adjacent to the p-type cladding layer. Here, the semiconductor of the same material basis means a compound having the same elements that form a compound semiconductor and including those different in composition ratio.

If the light emitting layer forming portion is formed by overlying layers of AlGaInP-based compound semiconductors, and the window layer of a p-type AlGaAs-based compound semiconductor being provided overlying the p-type cladding layer through the second p-type cladding layer of an AlGaInP-based compound semiconductor, a semiconductor light emittig device is available which is adapted for emitting red light with high brightness. Moreover, if the window layer is in a carrier concentration of 1× 10¹⁸ to 3× 10¹⁹ cm⁻³ , the voltae drops due to hetero-barriers can be prevented so that electric currents can sufficiently diffused, thus provideng a high brigntness semiconductor light emitting device.

Here, the AlGaInP-based compound semiconductor means a material represented in a form of (AlₓGa₁₋ₓ)_{0.51}In_{0.49}P wherein the value x is variable between 0 and 1. Meanwhile, the AlGaAs-based matrial means a material represented in a form of Al_{y}Ga_{1-y}As wherein the value y is variable between 0.6 and 0.8.

A method of manufacturing a semiconductor light emitting device according to the present invention comprises the steps of: (a) forming overlying a semiconductor substrate, in order, a light emitting layer forming portion having an n-type cladding layer, a non-doped active layer and a p-type cladding layer so that the p-type cladding layer has finally a carrier concentration of 1× 10¹⁶ to 5× 10¹⁶ cm⁻³ ; (b) growing a p-type window layer on the light emitting layer forming portion; and (c) forming electrodes respectively in electrical connection to the window layer and the semiconductor substrate.

If the semiconductor layers are formed by an MOCVD method so that the carrier concentraion is controlled by controlling the flow rate of a dopant gas introduced, the carrier concentation can be easy to control.

If the light emitting layer forming portion is formed by overlaying AlGaInP-based compound semiconductors, and the window layer being formed by overlaying an AlGaAs-based compound semiconductor, a semiconductor light emitting device adapted for emitting high-brightness red light is available.

If a step is further included to form a p-type second cladding layer by a semiconductor layer of the same material basis as the light emitting layer forming portion between the light emitting layer forming portion and the window layer while doping an impurity to a carrier concentration of 5× 10¹⁷ to 2× 10¹⁸ cm⁻³ , voltage drops due to hetero-barriers can be prevented.

### BRIEF DESCRIPTION OF THE DRAWINGS

Fig. 1 is a view showing a sectional structure of a semiconductor light emitting device according to the present invention;
Fig. 2 is a diagram showing a variation of light emitting intensity as the carrier concentration of a p-type cladding layer is varied.
Fig. 3 is a view showing a sectional view of an further improvement on the semiconductor light emitting device of the present invention;
Fig. 4 is a view showing a sectional structure of a conventional semiconductor light emitting device.

### BEST MODE FOR EMBODYING THE INVENTION

Now explanations will be made on a semiconductor light emitting device as well as a method of manufacturing the same according to the present invention with reference to the drawings.

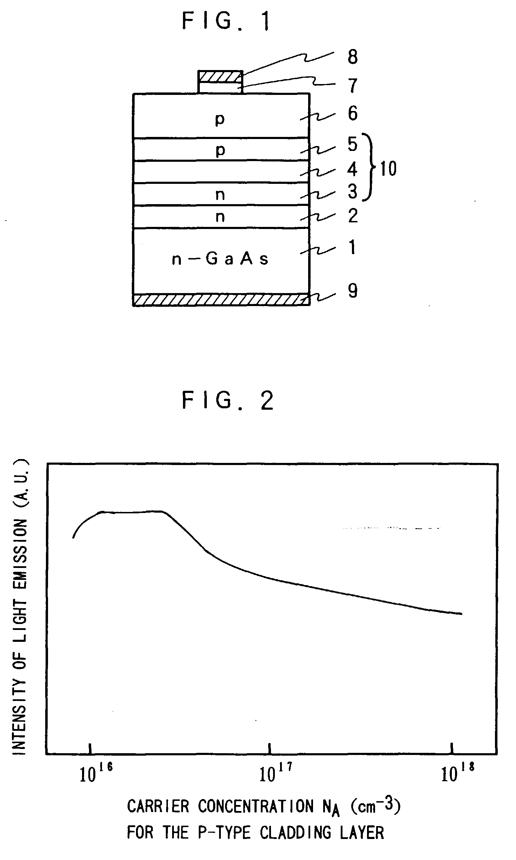

The semiconductor light emitting device of the present invention has a structure, as shown by a sectional explanatory view as one example in Fig. 1, having a semiconductor substrate 1 of a first conductivity type formed, for example, of an n-ype GaAs substrate; a light emitting layer forming portion 10 formed overlying the semiconductor sbstrate 1 to have an active layer 4 sandwched between an n-type cladding layer 3 and a p-type cladding layer 5, a window layer 6 of a second conductivity type provided on the light emitting layer forming portion 10 formed, for example, of a p-type AlGaAs-based compound semiconductor, a p-side electrode 8 and an n-side electrode 9 respectively-provided in electrical connection with the window layer 6 and the semiconductor substrate 1, wherein the p-type cladding layer is formed in a carrier concentration of 1× 10¹⁶ to 5× 10¹⁶ cm⁻³ .

As stated above, the present inventor has eagerly studied to improve light emitting efficiency for the conventional semiconductor light emitting device. As a result, it was found that the cause that no improvement of light emitting efficiency is available on the conventional semiconductor light emitting device is attributable for high impurity concentration in the p-type cladding layer so that the p-type impurity diffuses into the active layer to degrade the crystallinity of the active layer during epitaxially growing the cladding layer or the window layer. Under such a situation, the present inventor has eagerly studied on conditions under which the effect of the p-type impurity diffusing from the p-type cladding layer into the active layer is lowered. As a result, it was found, as shown in Fig. 2, that a higher light emitting efficiency is obtained by forming the p-type cladding layer while doping a p-type impurity so that the p-type cladding layer has finally a carrier concentration of 1× 10¹⁶ to 5× 10¹⁶ cm⁻³ . For finding the optimal range of the carrier concentration for the p-type cladding layer, a semiconductor light emitting device having a structure shown in Fig. 1 was employed.

That is, on a n-type GaAs substrate 1 are epitaxially grown, e.g. by an MOCVD method (Metal-organic Chemical Vapor Deposition) in order, a buffer layer 2 formed to a thickness of approximately 0.1 *µ* m of GaAs doped with selenium to a carrier concentration of approximately 1× 10¹⁸ cm⁻³ , an n-type cladding layer 3 formed to a thickness of approximately 0.5 *µ* m of (Al_{0.7}Ga_{0.3})_{0.51}In_{0.49}P doped with selenium to a carrier concentration of approximately 1× 10¹⁶ cm⁻³ , an active layer 4 formed to a thickness of approximately 0.5 *µ* m of non-doped (Al_{0.25}Ga_{0.75})_{0.51}In_{0.49}P, a p-type cladding layer 5 formed to a thickness of approximately 0.5 *µ* m of (Al_{0.7}Ga_{0.3})_{0.51}In_{0.49}P having a carrier concentration varied by varying the amount of zinc doping, a window layer 6 formed to a thickness of approximately 5 *µ* m of Al_{0.7}Ga_{0.3}As doped with zinc to a carrier concentration of approximately 1× 10¹⁸ cm⁻³ , and a contact layer 7 formed of GaAs doped with zinc to a carrier concentration of approximately 2× 10¹⁹ cm⁻³ .

An upper electrode (p-side electrode) 8, e.g. of an Au-Be-Ni alloy, and a lower electrode (n-side electrode) 9, e.g. of an Au-Ge-Ni alloy, are respectively formed on a top surface and a back surface of the substrate thus crystal-grown. The substrate is subjected to dicing to be made into individual devices. Incidentally, the contact layer 7 is provided for obtaining ohmic contact between the p-side electrode 8 and the window layer 6. Further, since a light radiating surface is provided at a top surface side of the semiconductor overlying layers, the p-side electrode 8 and the contact layer 7, which act to shield or absorb the light emitted by the light emitting layer forming portion 10, are patterned to have a minimal area for supplying electric currents. Further, the active layer 4 and the both cladding layers 3, 5, constituting the light emitting layer forming portion 10, are different in material, e.g. in Al crystal mixture ratio, to form a doublehetero structure for enhancing carrier confinement within the active layer.

With this semiconductor light emitting device structure, various semiconductor light emitting devices were manufactured having a p-type cladding layer different in carrier concentration by varying the concentration of the impurity doped with the other semiconductor layers other than the p-type cladding layer 5 grown under the above-stated conditions at all times. The manufactured devices were examined of their light emitting intensity, and the results are shown in Fig. 2. Incidentally, the carrier concentrations were measured on a single layer by a C-V measuring method (method for determining a carrier concentration from the dependency of depletion layer capacity), wherein the carrier concentration is rendered corresponding to the impurity amount (dopant gas flow rate) on each time.

In Fig. 2, the horizontal axis denotes the carrier concentration N_{A} (cm⁻³) for the p-type cladding layer 5, whereas the vertical axis represents the intensity of light emission in an arbitrary unit (a.u.) by the light emitting diode (LED) structured stated hereinbefore. It will be understood from Fig. 2 that the radiating intensity significantly lowers at a carrier concentration of the p-type cladding layer of, as conventionally, as high as approximately 1× 10¹⁷ to 1× 10¹⁸ cm⁻³ . The highest light emitting intensity is offered by doping the p-type impurity to 1× 10¹⁶ to 5× 10¹⁶ cm⁻³, wherein the light emitting intensity is improved by about 1.5 times as compared with the conventional case of the carrier concentration of the p-type cladding layer of approximately 1× 10¹⁷ to 1× 10¹⁸ cm⁻³ . If the carrier concentration is too low, the p-type cladding layer becomes high in electric resistance and the carrier is difficult to control, unfavorably giving rise to instability of quality.

To manufacture such a semiconductor light emitting device, an n-type GaAs substrate 1, for example, is placed within an MOCVD apparatus and reacting gasses of triethyle gallium (hereinafter referred to as TEG) or trimethyle gallium (hereinafter referred to as TMG), arsine (hereinafter referred to as AsH₃), and H₂Se as an Se dopant gas are introduced thereinto, together with a carrier gas of H₂ so that a buffer layer 2 of n-type GaAs doped with Se is grown to a carrier concentration of approximately 1× 10¹⁸ cm⁻³ to a thickness of approximately 0.1 *µ* m by epitaxially growing at a temperature of approximately 600 to 750 °C . Subsequently, by introducing phosphine (hereinafter referred to as PH₃) in place of AsH₃ and further trimethyle indium (hereinafter referred to as TMIn), an n-type cladding layer 3, for example, of n-type (Al_{0.7}Ga_{0.3})_{0.51}In_{0.49}P is epitaxially grown in a carrier concentration of approximately 5× 10¹⁶ to 1× 10¹⁸ cm⁻³ to a thickness of 0.5 *µ* m. The reacting gas TMA is decreased and TEG or TMG is increased to form an active layer 4 of non-doped (Al_{0.25}Ga_{0.75})_{0.51}In_{0.49}P to a thickness of approximately 0.5 *µ* m. Using a reacting gas similar to that for the n-type cladding layer 3 and introducing dimethylezinc (hereinafter referred to as DMZn) as a Zn dopant gas in place of H₂Se, a p-type cladding layer 5 of (Al_{0.7}Ga_{0.3})_{0.51}In_{0.49}P is epitaxially grown in a carrier concentration of approximately 1× 10¹⁶ to 5× 10¹⁶ cm⁻³ to a thickness of approximately 0.5 *µ* m.

Further, by introducing DMZn as a dopant gas and using TMA, TEG or TMG, and AsH₃ as reacting gases, a window layer 6 of Al_{0.7}Ga_{0.3}As is epitaxially grown in a carrier concentration of approximately 1× 10¹⁸ cm⁻³ to a thickness of approximately 5 *µ* m. Further, by introducing TEG or TMG, AsH₃, and DMZn, a contact layer 7 of GaAs is film formed in a carrier concentration of approximately 2× 10¹⁹ cm⁻³ to a thickness of approximately 0.05 to 0.2 *µ* m. Incidentally, in order to obtain a desired carrier concentration value, the carrier concentration increases with increase in flow rate of the dopant gas while the carrier concentration decreases with decrease in flow rate of the carrier gas .

The substrate thus epitaxially grown is formed at respective top and back surfaces with metal films such as of Au, Be, Ni, etc. by vacuum evaporation or the like, and subjected to annealing so that an Au-Be-Ni alloy upper electrode (p-side electrode) 8 and an Au-Ge-Ni alloy lower electrode (n-side electrode) 9 are formed thereon, followed by being subjected to dicing into individual chips.

Where employing the above-stated AlGaInP-based compound semiconductor (AlₓGa₁₋ₓ)_{0.51}In_{0.49}P for the light emitting layer forming portion, it is possible to obtain a semiconductor light emitting device especially excellent in light emitting characteristics by using a material with x of approximately 0 to 0.4 for the active layer and a material with x of approximately 0.6 to 1 for the cladding layer.

In the above embodiment, the semiconductor layers constituting the semiconductor light emitting device were exemplified in particular thickness or carrier concentrations by using detailed semiconductor materials. However, since there is a tendency of existing a preferred range of light emitting efficiency determined by the carrier concentration of the p-type cladding layer as stated above. It is accordingly possible to similarly obtain a semiconductor light emitting device structured with a light emitting layer forming portion 10 by sandwiching an active layer 4 between an n-type cladding layer 3 and a p-type cladding layer 5 as shown in Fig. 1 even if changes are made for the materials within a range for obtaining an ordinary semiconductor light emitting device, the thickness of the semiconductor layer, or the carrier concentration for the semiconductor layer other than the p-type layer.

Fig. 3 is a sectional explanatory view of a further improved structure of a semiconductor light emitting device of the present invention. In Fig. 3, the same parts as those of Fig. 1 are denoted by the same reference characters, thereby omitting explanations thereof. The embodiment shown in Fig. 3 is characterized by a p-type second cladding layer 5a formed to a thickness of approximately 0.5 *µ* m between the p-type cladding layer 5 and the window layer 6, which is epitaxially grown in the same material basis as the p-type cladding layer 5 (including materials having the same constituent elements but different in crystal mixture ratio of the elements) by doping an impurity such as zinc to a carrier concentration of as high as, for example, approximately 5× 10¹⁷ cm⁻³ . By providing the high carrier concentration of the semiconductor layer having the same material basis as the p-type cladding layer 5 in this manner, it is possible to prevent against voltage drops due to hetero-barriers. That is, voltage drops occur due to hetero-barriers, if there is a direct contact between a window layer 6 formed of an AlGaAs material with a carrier concentration of as high as approximately 1× 10¹⁸ to 3× 10¹⁹ cm⁻³ and a p-type cladding layer 5 formed of an AlGaInP-based compound semiconductor material with a carrier concentration of as low as approximately 3× 10¹⁶ cm⁻³ . However, by interposing a semiconductor layer that has the same material basis as the p-type cladding layer 5 and high in carrier concentration, there becomes no occurrence of voltage drops due to hetero-barriers and further the diffusion of p-type impurity into the active layer 4 is prevented, thus providing a high-characteristic semiconductor light emitting device. This interposed semiconductor layer, i.e. the second cladding layer 5a, if formed in a carrier concentration of approximately 5× 10¹⁷ to 2× 10¹⁸ cm⁻³ and to a thickness of 0.1 *µ* m or greater, can prevent against voltage drops due to hetero-barriers.

### INDUSTRIAL APPLICABILITY

According to the present invention, a semiconductor light emitting device high in light emitting efficiency and brightness is available without lowering the crystallinity for an active layer. Furthermore, there is no variation in diffusing a p-type impurity due to conditions for growing the crystal, thereby constantly providing a semiconductor light emitting device that is stable in brightness. It is possible to utilize as a light emitting element for light sources requiring high brightness such as outdoor displays, automobile tail lamps, direction indicators, and so on, and for light sources desired of low power consumption such as back-light light sources, indicator lighting units, and so on for battery-driven portable appliances.

## Claims

1. A semiconductr light emitting device comprising:
a semiconductor substrate of a first conductivity type;
a light emitting layer forming portion formed overlying said semiconductor sbstrate to have an active layer sandwched between an n-type cladding layer and a p-type cladding layer;
a window layer of a second conductivity type provided on said light emitting layer forming portion;
electrodes respectively provided in electrical connection with said window layer and said semiconductor substrate; and
wherein said p-type cladding layer is formed in a carrier concentration of 1× 10¹⁶ to 5× 10¹⁶ cm⁻³ .

2. A semiconduuctor light emitting device according to claim 1, further including a p-type second cladding layer provided on the opposite side to said p-type cladding layer with respect to said active layer and formed by a semiconductor layer of the same material basis as said p-type cladding layer to have a carrier concentration of 5× 10¹⁷ to 2× 10¹⁸ cm⁻³ .

3. A semiconducto light emitting device according to claim 2, wherein said light emitting layer forming portion is formed by overlying layers of AlGaInP-based compound semiconductors, and said window layer of a p-type AlGaAs-based compound semiconductor being provided overlying said p-type cladding layer through said second p-type cladding layer of an AlGainP-based compound semiconductor.

4. A semiconductor light emitting device according to claim 3, wherein said window layer is in a carrier concentration of 1× 10¹⁸ to 3× 10¹⁹ cm⁻³ .

5. A method of manufacturing a semiconductor light emitting device comprising the steps of:
(a) forming overlying a semiconductor substrate, in order, a light emitting layer forming portion having an n-type cladding layer, a non-doped active layer and a p-type cladding layer so that said p-type cladding layer has finally a carrier concentration of 1× 10¹⁶ to 5× 10¹⁶ cm⁻³ ;
(b) growing a p-type window layer on said light emitting layer forming portion; and
(c) forming electrodes respectively in electrical connection to said window layer and said semiconductor substrate.

6. A manufacturing method according to claim 5, wherein said semiconductor layers are formed by an MOCVD method so that the carrier concentraion is controlled by controlling the flow rate of a dopant gas introduced.

7. A manufacturing method according to claim 5, wherein said light emitting layer forming portion is formed by overlaying AlGaInP-based compound semiconductors, and said window layer being formed by overlaying an AlGaAs-based compound semiconductor.

8. A manufacturing method according to claim 5, further comprising a step of forming a p-type second cladding layer by a semiconductor layer of the same material basis as said light emitting layer forming portion between said light emitting layer forming portion and said window layer while doping an impurity to a carrier concentration of 5× 10¹⁷ to 2× 10¹⁸ cm⁻³ .
